(19) Europäisches Patentamt
European Patent Office
Office européen des brevets

(11) **EP 2 581 767 B1**

(12) **FASCICULE DE BREVET EUROPEEN**

(45) Date de publication et mention
de la délivrance du brevet:
**30.04.2014 Bulletin 2014/18**

(51) Int Cl.:
***G01V 11/00*** *(2006.01)*

(21) Numéro de dépôt: **12290301.6**

(22) Date de dépôt: **12.09.2012**

(54) **Méthode pour construire un maillage d'un réservoir fracturé avec un nombre limité de noeuds dans le milieu matrice**

Methode zur Erstellung eines Gitternetzes eines frakturierten Reservoirs mit einer begrenzten Anzahl von Knoten in einem Matrixmilieu

Method for constructing a mesh of a fractured reservoir with a limited number of nodes in the matrix environment

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.10.2011 FR 1103112**

(43) Date de publication de la demande:
**17.04.2013 Bulletin 2013/16**

(73) Titulaire: **IFP Energies Nouvelles**
**92852 Rueil Malmaison Cedex (FR)**

(72) Inventeurs:
• **Khvoenkova, Nina**
**92500 Rueil-Malmaison (FR)**
• **Delorme, Matthieu**
**92500 Rueil-Malmaison (FR)**

(56) Documents cités:
**FR-A1- 2 948 215    GB-A- 2 474 740**
**US-A1- 2006 235 666**

• **CHAMBERS K T ET AL: "Geologic modeling, upscaling and simulation of faulted reservoirs using faulted stratigraphic grids", PROCEEDINGS OF THE SPE RESERVOIR SIMULATION SYMPOSIUM, XX, XX, no. 51889, 14 février 1999 (1999-02-14), pages 1-12, XP002215912,**
• **BENNIS C ET AL: "ONE MORE STEP IN GOCAD STRATIGRAPHIC GRID GENERATION: TAKING INTO ACCOUNT FAULTS AND PINCHOUTS", PROCEEDINGS OF THE NPF/SPE EUROPEAN 3-D RESERVOIR MODELLINGCONFERENCE, XX, XX, 16 avril 1996 (1996-04-16), pages 307-316, XP000613094,**
• **LONGMIN RAN ET AL: "Hex-dominant mesh generation for basin modeling with complex geometry", I O P CONFERENCE SERIES: MATERIALS SCIENCE AND ENGINEERING, IOP, GB, vol. 10, 1 janvier 2010 (2010-01-01), pages 1-10, XP007918465, ISSN: 1757-8981, DOI: 10.1088/1757-899X/10/1/012085 [extrait le 2010-07-05]**

EP 2 581 767 B1

**Description**

La présente invention concerne le domaine de l'exploitation de gisements souterrains, tels que des gisements d'hydrocarbures comportant un réseau de fractures.

En particulier, l'invention concerne une méthode pour construire un maillage du milieu matriciel et ainsi construire une image du gisement. L'invention concerne également une méthode utilisant cette image pour optimiser la gestion d'une telle exploitation au moyen d'une prédiction des écoulements de fluides susceptibles de se produire à travers ce milieu, pour simuler une production d'hydrocarbures suivant divers scénarios de production.

L'industrie pétrolière, et plus précisément l'exploration et l'exploitation de gisements, notamment pétroliers, nécessitent d'acquérir une connaissance aussi parfaite que possible de la géologie souterraine pour fournir de façon efficace une évaluation des réserves, une modélisation de la production, ou la gestion de l'exploitation. En effet, la détermination de l'emplacement d'un puits de production ou d'un puits d'injection, la constitution de la boue de forage, les caractéristiques de complétion, le choix d'un procédé de récupération des hydrocarbures (tel que l'injection d'eau par exemple) et des paramètres nécessaires à la mise en oeuvre de ce procédé (tels que la pression d'injection, le débit de production,...) nécessitent de bien connaître le gisement. Connaître le gisement signifie notamment connaître les propriétés pétrophysiques du sous-sol en tout point de l'espace, et pouvoir y prévoir les écoulements susceptibles de s'y produire.

Pour ce faire, depuis longtemps, l'industrie pétrolière allie les mesures sur champ (in situ) aux modélisations expérimentales (réalisées au laboratoire) et/ou numériques (réalisées au moyen de logiciels). Les modélisations des gisements pétroliers constituent donc une étape technique indispensable à toute exploration ou exploitation de gisement. Ces modélisations ont pour but de fournir une description du gisement.

Les réservoirs fracturés constituent un type extrême de réservoirs hétérogènes comportant deux milieux contrastés, un milieu matriciel contenant la plus grande part de l'huile en place et présentant une faible perméabilité, et un milieu fracturé représentant moins de 1 % de l'huile en place et hautement conducteur. Le milieu fracturé lui-même peut être complexe, avec différents ensembles de fractures caractérisés par leur densité, longueur, orientation, inclinaison et ouverture respectives. Le milieu fracturé est l'ensemble des fractures. Le milieu matriciel est l'ensemble de la roche autours du milieu fracturé.

Les spécialistes en charge de l'exploitation de réservoirs fracturés, ont besoin de parfaitement connaître le rôle des fractures. On appelle *"fracture"*, une discontinuité plane, de très faible épaisseur par rapport à son extension, et qui représente un plan de rupture d'une roche du gisement. D'une part, la connaissance de la distribution et du comportement de ces fractures permet d'optimiser la localisation et l'espacement entre les puits que l'on compte forer au travers du gisement pétrolifère. D'autre part, la géométrie du réseau de fractures conditionne le déplacement des fluides tant à l'échelle du réservoir qu'à l'échelle locale où elle détermine des blocs matriciels élémentaires dans lesquels l'huile est piégée. Connaître la distribution des fractures, est donc très utile, aussi, à un stade ultérieur, pour l'ingénieur de réservoir qui cherche à calibrer les modèles qu'il construit pour simuler les gisements, afin d'en reproduire ou prédire les courbes de production passées ou futures. A ces fins, les spécialistes de géosciences disposent d'images tridimensionnelles des gisements, permettant de localiser un grand nombre de fractures.

Ainsi, pour reproduire ou prédire (i.e. "simuler") la production d'hydrocarbures lors de la mise en production d'un gisement suivant un scénario de production donné (caractérisé par la position des puits, la méthode de récupération, ...), le spécialiste en ingénierie de réservoir met en oeuvre un logiciel de calcul, appelé « simulateur de réservoir » (ou « simulateur d'écoulement »), qui calcule les écoulements et l'évolution des pressions au sein du réservoir représenté par le modèle de réservoir (image du réservoir). Les résultats de ces calculs lui permettent de prévoir et d'optimiser le gisement en termes de débit et/ou de quantité d'hydrocarbures récupérés. Le calcul du comportement du réservoir suivant un scénario de production donné constitue une « simulation de réservoir ».

Pour réaliser des simulations d'écoulement autour d'un puits ou à l'échelle de quelques mailles (~km$^2$) de réservoir, en prenant en compte un réseau de fractures discret géologiquement représentatif, il est nécessaire de construire un maillage du milieu matriciel (roche) et un maillage du milieu fracturé. Ce dernier doit être adapté aux hétérogénéités géométriques (localisation des failles et fractures diffuses en trois dimensions) et dynamiques, puisque le milieu fracturé est souvent bien plus conducteur de fluides que le milieu matriciel. Ces zones de simulation, si elles sont fracturées, peuvent compter jusqu'à un million de fractures, de tailles variant de un à plusieurs centaines de mètres, et de géométries très variables : pendage, azimut, forme.

Cette étape est très utile pour la calibration hydrodynamique des modèles de fractures. En effet, la discontinuité des propriétés hydrauliques (la perméabilité dominante dans les fractures et la capacité de stockage dans la matrice) amène souvent à utiliser l'approche double milieu (propriétés homogénéisées) sur des modèles réservoir (maille hectométrique). Ces modèles sont basés sur l'hypothèse que le volume élémentaire représentatif (VER) est atteint dans la maille et que la fracturation du milieu est suffisamment importante pour pouvoir appliquer les méthodes d'homogénéisation (la périodicité stochastique de fracturation est utilisée par exemple).

Dans le cadre de l'exploitation de gisements pétroliers, les méthodes discrètes de simulation d'écoulement sont utilisées, notamment, pour la mise à l'échelle des perméabilités (à l'échelle d'une cellule de réservoir) et pour les tests dynamiques (une zone d'intérêt (ZOI) de taille petite comparée à celle du réservoir). Les temps de calcul apparaissent comme primordiaux puisque le calcul est souvent effectué séquentiellement et un grand nombre de fois dans des boucles d'optimisation. Il est connu que dans le cas de fracturation dense (fractures très connectées), les méthodes analytiques sont applicables tandis que dans le cas d'indice de connectivité faible, la simulation numérique sur un réseau discret de fractures (DFN) est nécessaire.

Le modèle numérique, c'est à dire la matrice de transmissivités relatives aux différents objets (failles, diffuses, mailles du milieu matriciel) doit respecter un certain nombre de critères en double milieu:

- être applicable à un nombre important de fractures (plusieurs milliers de fractures) ;

- restituer la connectivité du réseau de fractures ;

- être évolutif afin de prendre en compte tous les modèles de fractures (plusieurs échelles de fracturation, fractures désordonnées en 3D, failles étanches, propriétés dynamiques dans le temps, ...) ;

- la forme des fractures (polygones convexes plans quelconques ou ellipses) et les hétérogénéités d'intersection entre les fractures en 3D doivent être prises en compte lors du maillage plan de chacune des fractures ;

- Modéliser l'évolution du champ de pression dans le milieu "matrice" (moins conducteur et contenant plus de fluide) en fonction du champ de pression dans les fractures grâce à des termes de transmissivité (échange matrice/Fracture).

- le nombre de noeuds de simulations, c'est à dire le nombre d'inconnus en pression, doit être restreint pour pouvoir utiliser un solveur numérique (on appelle noeud, un élément volumique du milieu fracture ou matrice, qui porte une valeur inconnue de pression

- être rapide et peu coûteux en mémoire (utilisable sur un poste usuel et pas uniquement sur un supercalculateur).

Avec de tels besoins, les maillages classiques (éléments finis ou volumes finis) ainsi que les méthodes qui en dérivent pour une construction locale des transmissivités ne sont pas applicables à cause d'un nombre de noeuds nécessaires à la simulation trop élevé.

On connait également la technique mise en oeuvre dans le logiciel FracaFlow™ (IFP Energies nouvelles, France) qui permet de dépasser ces limites en utilisant une approche physique basée sur des solutions analytiques de problèmes d'écoulement plans. Les fractures y sont supposées contraintes par les bancs géologiques (elles les traversent entièrement) et être sub-verticales. Une fracture est dite contrainte aux bancs si elle s'interrompt sur des changements de banc géologique. Ces hypothèses assurent que toutes les intersections ont lieu sur tout plan intermédiaire parallèle aux couches géologiques. Dans le plan médian de chaque banc géologique, les noeuds sont placés sur les intersections (un point) des fractures sur le plan (un noeud matrice et un noeud fracture au même endroit). Les connexions verticales sont portées par les fractures traversant plusieurs couches et les volumes associés aux noeuds sont calculés comme l'ensemble des points (sur le plan 2D, propagé verticalement à l'épaisseur de la couche) les plus proches du noeud (dans le milieu considéré).

Cette méthode atteint ses limites lorsque les fractures ne sont pas contraintes aux bancs et/ou le pendage des fractures n'est pas vertical. Les intersections ne sont en effet plus présentes sur chaque plan intermédiaire et la connectivité verticale ne peut plus être honorée. En augmentant le nombre de plans intermédiaires, l'erreur commise peut être réduite (sans jamais être exacte dans le cas de fractures sub-horizontales) mais le nombre de noeuds augmente considérablement et dépasse les limites imposées par les solveurs.

**La méthode selon l'invention**

De façon générale, l'invention concerne un procédé pour optimiser l'exploitation d'un gisement de fluide traversé par un réseau de fractures, dans lequel on discrétise ledit gisement en un ensemble de mailles, chaque maille comportant un milieu matriciel et un milieu fracture, on construit en chaque maille à partir d'observations dudit gisement un réseau discret de fractures (DFN). Le procédé comporte les étapes suivantes :

- on construit un maillage du réseau discret de fractures en définissant un ensemble de cellules pour chaque fracture ;

- on construit un maillage du milieu matriciel en divisant chaque maille au moyen d'une technique d'octree, dans laquelle une maille est divisée en huit cellules, les cellules issues d'une division étant elles-mêmes divisées en huit, jusqu'à ce que chaque cellule issue de division comporte un nombre de fractures inférieur ou égal à un seuil donné ;

- on détermine des transmissivités entre lesdites cellules du maillage de fracture, des transmissivités entre lesdites cellules du maillage du milieu matriciel, et des transmissivités entre des cellules du maillage de fracture et des cellules du maillage du milieu matriciel ;

- on utilise lesdites cellules et les dites transmissivités pour construire une image du gisement de fluide ;

- on utilise ladite image du gisement de fluide et un simulateur d'écoulement pour optimiser l'exploitation dudit gisement de fluide.

Selon l'invention, on peut construire le maillage du milieu matriciel au moyen d'une technique d'octree équilibré d'ordre 1.

Selon un mode de réalisation, les cellules issues d'une division sont elles-mêmes divisées en huit, jusqu'à ce que chaque cellule issue de division comporte un nombre de fractures inférieur ou égal à un seuil donné, ou jusqu'à ce que ce que le nombre de cellules soit inférieur ou égal à un seuil donné.

Selon l'invention, on peut déterminer les transmissivités entre lesdites cellules du maillage du milieu matriciel et le milieu fracture en fonction d'un volume d'influence d'un noeud fracture i, $\Omega_{M_i}$, défini comme l'ensemble des points d'une cellule du maillage du milieu matriciel dont le noeud fracture le plus proche est le noeud fracture i, et en fonction d'une distance moyenne $\langle l_{mFi} \rangle_{\Omega M_i}$ par rapport au noeud fracture i sur $\Omega_{M_i}$ .et en supposant qu'aucun flux ne circule entre ces volumes d'influence.

Selon un mode de réalisation, chaque fracture est représentée au sein du réseau discret de fractures par un plan fini polygonal isotrope du point de vue de ses propriétés dynamiques, ledit plan pouvant comporter au moins un segment d'intersection correspondant à une intersection entre ladite fracture et une autre fracture dudit réseau, et on réalise les étapes suivantes :

a) on construit un diagramme de Voronoï sur chaque plan de fracture en positionnant des centres de cellules de Voronoï sur lesdits segments d'intersection ;

b) on calcule des transmissivités entre des centres de cellules de Voronoï voisines à partir du rapport entre la surface des cellules voisines et la distance entre les cellules voisines.

Selon ce mode de réalisation, on peut positionner les centres de cellules de Voronoï sur lesdits segments d'intersection, en appliquant la règle suivante : chaque segment d'intersection est au moins discrétisé par deux noeuds intermédiaires de Voronoï à chacune des extrémités dudit segment, et raffiné dans le cas de segments proches et de segments qui se croisent.

On peut aussi limiter le nombre de cellules en procédant à un assemblage des cellules de Voronoï appartenant à un même segment d'intersection, tant que la cellule issue de l'assemblage reste connexe.

La transmissivité entre deux cellules issues de l'assemblage est avantageusement égale à la somme des transmissivités via les frontières les séparant selon la conservation du flux.

Enfin, on peut déterminer les segments d'intersection au moyen d'une technique d'octree, dans laquelle une maille est divisée en huit cellules, les cellules issues d'une division étant elles-mêmes divisées en huit, jusqu'à ce que chaque cellule issue de division comporte un nombre de fractures inférieur ou égal à un seuil donné.

D'autres caractéristiques et avantages de la méthode selon l'invention, apparaîtront à la lecture de la description ci-après d'exemples non limitatifs de réalisations, en se référant aux figures annexées et décrites ci-après.

**Présentation succincte des figures**

- La figure 1 illustre les différentes étapes de la méthode selon l'invention.

- La figure 2 illustre une réalisation d'un réseau de fractures/failles à l'échelle d'un réservoir

- La figure 3 illustre un réseau de fracture discret (DFN)

- La figure 4 illustre un exemple de plan de fracture composé de six sommets et quatre segments d'intersection coplanaires dont une intersection multiple avec d'autres fractures.

- La figure 5 illustre la création des centres de cellules de Voronoï pour l'exemple choisi (figure 4), selon le théorème de Koëbe.

- La figure 6 illustre la construction, à partir de la figure 5, du diagramme de Voronoï infini, avec détermination des frontières et des cellules voisines.

- La figure 7 illustre le résultat du «clipping» appliqué à l'image de la figure 6.

- La figure 8 illustre l'assemblage des cellules de Voronoï pour créer les «noeuds fracture» (ici six «noeuds fractures» caractérisés chacun par une couleur).

- La figure 9 illustre l'assemblage des cellules de Voronoï dans le cas où le « noeud fracture » ne correspond pas aux noeuds de Voronoï, avec calcul d'une correction de l'ensemble des transmissivités.

- La figure 10 montre trois cellules de maillage matrice de tailles différentes.

- La figure 11 montre un maillage Matrice appliqué à un DFN.

**Description détaillée de la méthode**

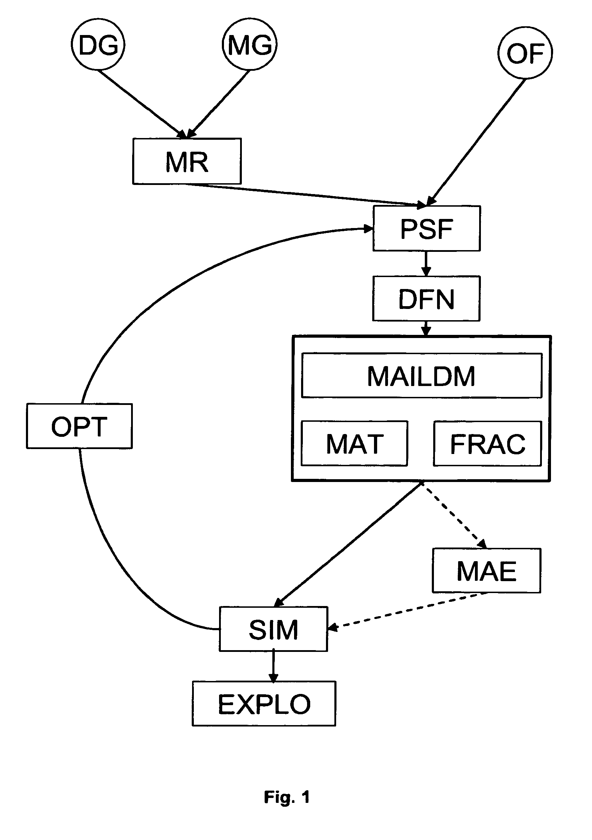

La méthode selon l'invention pour optimiser l'exploitation d'un gisement, utilisant la méthode de construction d'un maillage du milieu matriciel, comporte six étapes, les quatre premières étant mises en oeuvre par un ordinateur, comme illustré sur la figure 1 :

1- Discrétisation du gisement en un ensemble de mailles **(MR)**

2- Modélisation du réseau de fractures par un modèle de fracture discret **(DFN)**

3- Construction d'un maillage double milieu **(MAILDM)**

    3-a Construction d'un maillage du milieu fracture **(FRAC)**

    3-b Construction d'un maillage du milieu matriciel **(MAT)**

4- Simulation des écoulements de fluides **(SIM)**

5- Optimisation des conditions de production du gisement **(OPT)**

6- Exploitation (globale) optimisée du gisement **(EXPLO)**

1- Discrétisation du gisement en un ensemble de mailles **(MR)**

Depuis longtemps, l'industrie pétrolière allie les mesures sur champ (in situ) aux modélisations expérimentales (réalisées au laboratoire) et/ou numériques (réalisées au moyen de logiciels). Les modélisations des gisements pétroliers, constituent donc une étape technique indispensable à toute exploration ou exploitation de gisement. Ces modélisations ont pour but de fournir une description du gisement, caractérisée par la structure/géométrie et les propriétés pétrophysiques des dépôts ou formations géologiques qui le constituent.

Ces modélisations se basent sur une image du gisement, construite en discrétisant le gisement en un ensemble de mailles (dans la description une maille correspond à un noeud). Chacune de ces mailles représente un volume donné du gisement, et constitue un volume élémentaire du gisement. L'ensemble des mailles constitue une image discrète du gisement, appelée modèle de réservoir.

Les spécialistes connaissent de nombreux outils logiciels permettant de construire de tel modèle de réservoir, à partir de données **(DG)** et mesures **(MG)** relatives au gisement. Dans le cas des réservoirs fracturés, les propriétés dans le milieu fracture et dans le milieu matrice sont souvent très hétérogènes. Pour bien prendre en compte ces hétérogénéités, un modèle d'écoulements double milieu est fréquemment utilisé.

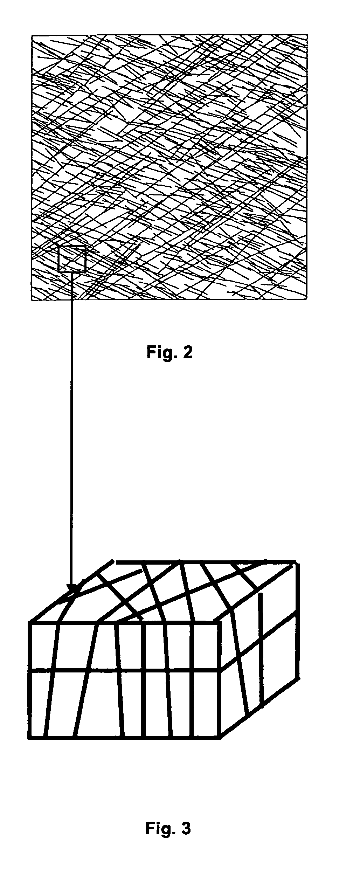

La figure 2 illustre une vue en deux dimensions d'un modèle de réservoir. Les fractures sont représentées par des lignes. Les mailles ne sont pas représentées.

2- Modélisation du réseau de fractures

Pour prendre en compte le rôle du réseau de fractures dans la simulation des écoulements au sein du gisement, il est nécessaire d'associer à chacun de ces volumes élémentaires (mailles du modèle de réservoir) une modélisation du milieu fracturé.

*Caractérisation des fractures*

Les spécialistes en charge de la caractérisation statistique du réservoir, réalisent des observations (OF) directes et indirectes du réservoir. Pour cela, ils disposent 1) de carottes de puits extraites du réservoir sur lesquelles une étude statistique des fractures intersectées est effectuée, 2) d'affleurements caractéristiques du réservoir qui présentent l'avantage de fournir une vision à grande échelle du réseau de fractures 3) d'images sismiques leur permettant d'identifier de grands événements géologiques.

Ces mesures permettent de caractériser les fractures par des paramètres statistiques (PSF) : leur densité, leur longueur, leur orientation azimutale, leur inclinaison et leur ouverture respectives, et bien sur, leur distribution au sein du réservoir.

A l'issue de cette étape de caractérisation des fractures, nous disposons de paramètres statistiques (PSF) décrivant les réseaux de fractures à partir desquels des images réalistes des réseaux réels (géologiques) peuvent être reconstruites (générées) à l'échelle de chacune des mailles (cellules) du modèle de réservoir considéré (domaine de simulation).

L'objectif de la caractérisation et de la modélisation du réseau de fractures de gisement, est de proposer un modèle de fractures validé sur les écoulements locaux autour des puits. Ce modèle de fractures est alors étendu à l'échelle du réservoir afin de réaliser des simulations de production. Pour ce faire, on associe des propriétés d'écoulement à chaque maille du modèle de réservoir (MR) (tenseur de perméabilité, porosité) des deux milieux (fracture et matrice).

Ces propriétés peuvent être déterminées, soit directement à partir des paramètres statistiques (PSF) décrivant les réseaux de fractures, soit à partir d'un réseau de fracture discret (DFN) représentatif obtenu à partir des paramètres statistiques (PSF).

*Construction d'un réseau de fracture discret (DFN) - Figure 2 et 3*

A partir d'un modèle de réservoir du gisement étudié, on lui associe en chaque maille une image détaillée (DFN) de la complexité interne du réseau de fractures aussi fidèle que possible des observations directes et indirectes du réservoir. La figure 2 illustre une réalisation d'un réseau de fractures/failles à l'échelle d'un réservoir. Chaque maille du modèle de réservoir représente ainsi un réseau discret de fractures délimitant un ensemble de blocs matriciels poreux, de formes et tailles irrégulières, délimités par des fractures. Une telle image est représentée sur la figure 3. Ce réseau de fracture discret constitue une image représentative du réseau réel de fractures délimitant les blocs matriciels.

Pour construire un réseau de fracture discret en chaque maille d'un modèle de réservoir, on peut utiliser des logiciels de modélisation, bien connus des spécialistes, tel que le logiciel FRACAFlow® (IFP Energies nouvelles, France). Ces logiciels utilisent les paramètres statistiques déterminés à l'étape de caractérisation des fractures.

Ainsi, au sein du réseau discret de fractures (DFN), chaque fracture est représentée par un plan fini polygonal isotrope du point de vue de ses propriétés. C'est-à-dire que toute propriété de la faille (hydrauliques telles que les conductivités) est homogène sur ce plan. Ce plan peut comporter au moins un segment d'intersection correspondant à une intersection entre la fracture et une autre fracture du réseau.

3- Construction d'un maillage du modèle double milieu (MAILDM)

A ce stade, l'ingénieur de réservoir souhaite réaliser des simulations d'écoulement pour calibrer au mieux les propriétés d'écoulement du réseau de fractures. Les spécialistes ont à leur disposition de nombreuses techniques pour construire un tel maillage et résoudre les équations d'écoulement.

En considérant que l'équation de conservation de la masse est vérifiée dans un milieu poreux fracturé, et puisque l'équation de Darcy est supposée être vérifiée dans le milieu matrice ($\Omega_M$) et dans le milieu fracture ($\Omega_F$) avec la continuité du flux normal sur la frontière matrice/fracture $\partial\Omega_{FM}$ (avec $\Omega_M \cup \Omega_F \cup \partial\Omega_{FM} = \Omega$), on peut écrire :

$$\begin{cases} \phi_F \chi \dfrac{\partial P_F}{\partial t} - div\left(\dfrac{\overline{\overline{K_F}}}{\mu}\vec{\nabla}P_F\right) = Q_F, \quad dans \quad \Omega_F \\[3mm] \phi_M \chi \dfrac{\partial P_M}{\partial t} - div\left(\dfrac{\overline{\overline{K_M}}}{\mu}\vec{\nabla}P_M\right) = Q_M, \quad dans \quad \Omega_M \\[3mm] \dfrac{\overline{\overline{K_F}}}{\mu}.\vec{\nabla}P_F.\vec{n}_F = -\dfrac{\overline{\overline{K_M}}}{\mu}.\vec{\nabla}P_M.\vec{n}_M, \quad sur \quad \partial\Omega_{FM} \end{cases}$$

où

$P_{F,M}(x,y,z,t)$ sont les pressions respectives de chaque milieu (fracture et matrice),

$Q_{F,M}(x,y,z,t)$ les termes source,

$\chi = c_R + c_{fl} = c_R + \sum\limits_{i=fluide} S_{fl\_i} c_i$ la compressibilité totale du milieu,

$c_R$ la compressibilité de la roche,

$c_{fl}$ la compressibilité du fluide,

$K_{F,M}(x, y, z)$ les perméabilités respectives fracture et matrice dans l'espace,

$\phi_{F,M}(x, y, z)$ les porosités respectives des milieux fracture et matrice dans l'espace,

$\mu$ la viscosité du fluide (constante).

En utilisant le théorème de Green-Ostrogradski on peut réécrire ce système sous sa forme intégrale:

$$\begin{cases} \displaystyle\int_{\Omega_F} \phi_F \chi \dfrac{\partial P_F}{\partial t} + \int_{\partial\Omega_{FM}} \dfrac{\overline{\overline{K_F}}}{\mu}.\vec{\nabla}P_F.\vec{n}_F dS = \int_{\partial\Omega_F} \dfrac{\overline{\overline{K_F}}}{\mu}.\vec{\nabla}P_F.\vec{n}_{ext} dS \\[4mm] \displaystyle\int_{\Omega_M} \phi_M \chi \dfrac{\partial P_M}{\partial t} + \int_{\partial\Omega_{FM}} \dfrac{\overline{\overline{K_M}}}{\mu}.\vec{\nabla}P_M.\vec{n}_M dS = \int_{\partial\Omega_M} \dfrac{\overline{\overline{K_M}}}{\mu}.\vec{\nabla}P_M.\vec{n}_{ext} dS \\[4mm] \displaystyle\int_{\partial\Omega_{FM}} \dfrac{\overline{\overline{K_F}}}{\mu}.\vec{\nabla}P_F.\vec{n}_M dS = \int_{\partial\Omega_{FM}} \dfrac{\overline{\overline{K_M}}}{\mu}.\vec{\nabla}P_M.\vec{n}_M dS \\[4mm] \displaystyle\int_{\partial\Omega_F} \dfrac{\overline{\overline{K_F}}}{\mu}.\vec{\nabla}P_F.\vec{n}_{ext} dS = \int_{\partial\Omega_F} Q_F.\vec{n}_{ext} dS \\[4mm] \displaystyle\int_{\partial\Omega_M} \dfrac{\overline{\overline{K_M}}}{\mu}.\vec{\nabla}P_M.\vec{n}_{ext} dS = \int_{\partial\Omega_M} Q_M.\vec{n}_{ext} dS \end{cases}$$

3-a Construction d'un maillage du milieu fracture **(FRAC)**

Selon un mode de réalisation préféré, on utilise une méthode qui permet de construire un maillage fin sur tout réseau discret de fractures 3D avec un nombre optimal de noeuds, proche du nombre d'intersections entre les fractures connectées. La connectivité du réseau de fractures discret (DFN) à l'échelle de l'étude (une zone d'intérêt de quelques milliers de mètres carrés) est respectée dans le but de simuler des écoulements. Cette méthode de maillage de chaque plan de fractures dans l'espace 3D est applicable à tous les problèmes d'écoulement dans un plan 2D avec des discontinuités au niveau des propriétés hydrauliques. Cette méthode comporte essentiellement deux étapes :

a) on construit un diagramme de Voronoï sur chaque plan de fracture en positionnant des centres de cellules de Voronoï sur les segments d'intersection ;

b) on calcule les transmissivités entre les centres de cellules voisines à partir du rapport entre la surface des cellules voisines et la distance entre les cellules voisines.

Les cellules du maillage fracturé sont construites à partir d'un diagramme de Voronoï de segments de façon à limiter à un seul milieu homogène l'espace d'échange entre deux noeuds fracture tout en respectant localement la physique d'écoulement en milieu homogène. La discontinuité due à toute intersection de fractures est modélisée grâce à la construction du maillage. Une fois les noeuds positionnés, une formulation simple et physique est utilisée pour calculer les transmissivités : termes de liaisons entre les noeuds. Cette méthode, appliquée ici au maillage du milieu fracturé 3D, s'applique à tout problème 3D de segments d'hétérogénéités désordonnés et reliés par des plans de propriété homogène

De façon physique, nous supposons que l'intersection entre deux fractures est une hétérogénéité, l'endommagement est supposé plus grand, dans chacun des plans relatifs aux fractures respectives. Or, dans un milieu homogène, le fluide prendra le chemin nécessitant le moins d'énergie pour se déplacer d'un point à un autre. Puisque nous supposons que le gradient de pression le long de l'intersection est plus faible que dans la fracture (perméabilité plus forte), pour passer d'une intersection à une autre, le fluide emploiera le chemin de plus courte distance entre les deux segments d'intersection. Ce qui nous conduit, pour chaque fracture, à calculer le diagramme de Voronoï de segment 2D sur les intersections. Ce diagramme a en effet l'avantage de délimiter les zones d'influences de chaque fracture.

1. Le maillage du milieu fracturé est construit, sur le DFN, dans le but d'avoir le moins de noeuds possibles. Pour honorer pleinement la connectivité, les noeuds fractures sont placés sur les intersections des fractures en 3D (un ou plusieurs noeuds par segment d'intersection).

2. Les isopressions, orthogonales au gradient de pression et donc aux lignes de courant dans chaque plan de fracture homogène, sont supposées parallèles aux intersections.

3. Les cellules du maillage sont construites à partir d'un diagramme de Voronoï de segments sur chaque plan de fractures. Cette construction à l'avantage de:

- limiter à un seul milieu homogène (le plan d'une fracture) l'espace d'échange entre deux noeuds fractures,

- de respecter localement, l'orthogonalité entre la ligne de courant (entre deux noeuds) et la frontière des cellules.

- faciliter le calcul approché du gradient de pression entre les noeuds le long de la frontière.

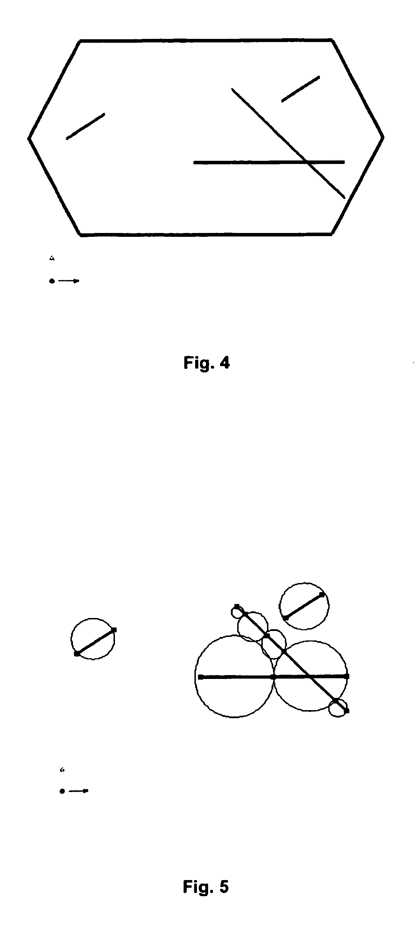

Selon l'invention, chaque fracture est représentée par un plan fini polygonal isotrope du point de vue de ses propriétés dynamiques. Chaque plan peut comporter au moins un segment d'intersection correspondant à une intersection entre ladite fracture et une autre fracture du réseau (DFN). La figure 4 illustre un exemple composé d'une fracture à six sommets et quatre segments d'intersection coplanaires dont une intersection multiple. La méthode pour mailler ce plan comporte les étapes suivantes :

1. Pour chaque intersection, création d'un noeud fracture (un noeud au centre de chaque intersection, on garde l'information sur les coordonnées des deux extrémités). Dans le cas d'une intersection multiple (trois fractures au moins s'intersectent en un même point), on remplace le noeud initial au centre du segment par deux noeuds de part et d'autre du point. Le but de ce prétraitement est d'assurer la connexité de toute maille fracture.

2. Construction du diagramme de Voronoï sur chaque plan de fracture à partir des segments d'intersection en appliquant le théorème de Koëbe. C'est à dire que chaque segment est au moins discrétisé par deux noeuds intermédiaires de Voronoï à chacune des extrémités et raffiné dans le cas de segments trop proches ou de segments qui se croisent. Cette construction peut se décomposer selon les étapes suivantes :

i. Création de l'ensemble des centres de cellules de Voronoï: points vérifiant le théorème des "Kissing disks" de Koebe-Andreev-Thurston (P. Koebe. Kontaktprobleme der konformen Abbildung. Ber. S"achs. Akad. Wiss. Leipzig, Math.-Phys. KI., 88:141-164, 1936.) sur chaque intersection contenue dans le plan de la fracture : chaque segment est au moins discrétisé par deux noeuds intermédiaires de Voronoï à chacune des extrémités du segment, et raffiné dans le cas segments qui se croisent et de segments trop proches (la notion de proximité dépend de la distance à partir de laquelle on estime que deux points sont confondus. Il s'agit d'un paramètre de précision géométrique que l'utilisateur peut définir en fonction de la taille du domaine d'étude par rapport à la taille des fractures notamment). La figure 5 illustre la création des centres de cellules de Voronoï pour l'exemple choisi (figure 4), selon le théorème de Koëbe. On s'assure ici que pour chaque triplet de points, le cercle dont le centre est le milieu de deux des points ne contient pas le troisième point.

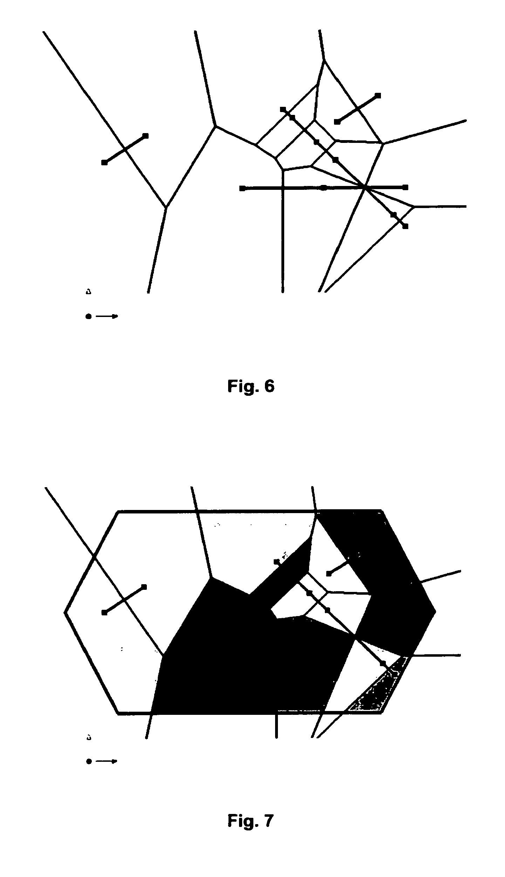

ii. Construction du diagramme de Voronoï sur ces points en utilisant l'algorithme de S.Fortune (S. J. Fortune, A sweepline algorithm for Voronoï diagrams, Algorithmica 2 (1987), 153-174.), prouvé être le plus rapide sur un plan 2D infini. La figure 6 illustre la construction du diagramme de Voronoï infini, avec détermination des frontières et des cellules voisines.

iii. « Clipping » du diagramme de Voronoï infini par rapport au polygone fini définissant la fracture. Le « clipping » désigne le fait de borner le résultat d'un visuel à un domaine donné. A ce stade, les cellules de Voronoï sont convexes et la ligne passant par les centres de deux cellules voisines est orthogonale à la frontière qui les sépare. Une telle géométrie permet d'approximer plus facilement le gradient de pression entre les noeuds le long de la frontière. La figure 7 illustre le résultat du « clipping » appliqué à l'image de la figure 6.

3. Calcul fin des transmissivités entre les centres des cellules voisines du diagramme.

On calcule les transmissivités (Tff) entre les centres de cellules voisines à partir du rapport entre la surface (Sc) des cellules voisines et la distance (Dc) entre les cellules voisines :

$$Tff = K.Sc/Dc$$

avec K, la perméabilité de la fracture dans laquelle se produit l'écoulement

4. Assemblage de cellules de Voronoï

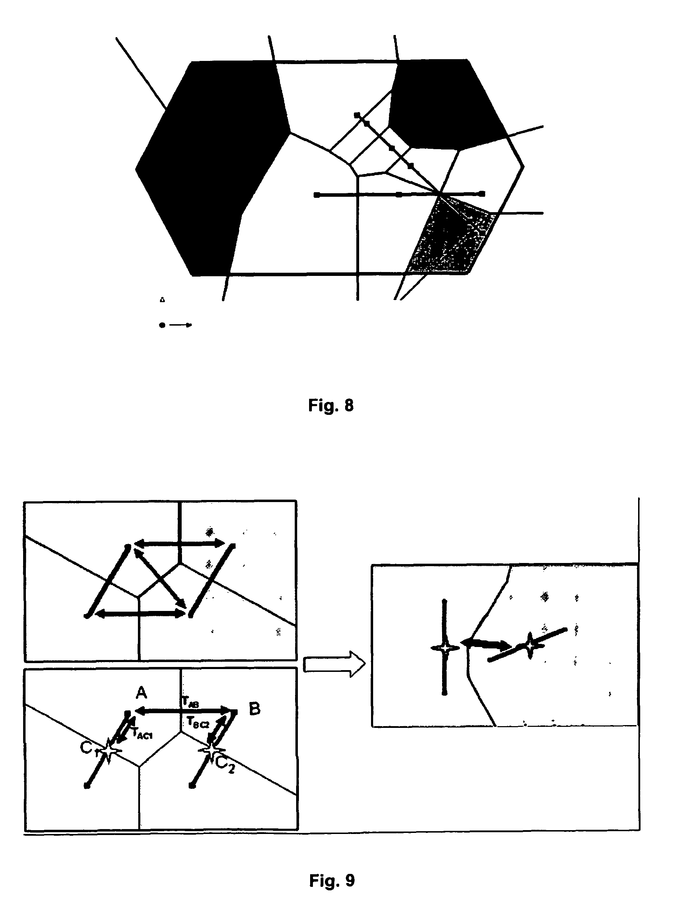

Nous supposons que l'endommagement à l'intersection entre deux fractures est plus grand que dans les plans respectifs des fractures. Il en résulte une prise en compte des discontinuités de conductivités sur le plan de fracture localement le long des intersections. Les lignes d'isopression dans chaque plan de fracture correspondent alors aux lignes d'équidistance entre les traces d'intersection. Le diagramme de Voronoï de segments répond à ce critère, les cellules de ce diagramme deviennent les mailles fractures (connexes par construction) associées au noeud. Pour limiter le nombre de noeuds nous procédons à un assemblage des cellules de Voronoï appartenant à un même segment d'intersection tant que la cellule reste connexe (c'est à dire que les cellules appartiennent au même segment et qu'il n'y a pas d'intersection multiple). La figure 8 illustre l'assemblage des cellules de Voronoï pour créer les « noeuds fracture » (ici six « noeuds fractures » caractérisés chacun par une couleur).

Ensuite, les volumes sont sommés, la transmissivité entre deux « noeuds fracture » est égale à la somme des transmissivités via les frontières les séparant selon la conservation du flux. Si un noeud fracture $A$ contient plusieurs points Voronoï $P_{Ai}$ et un noeud $B$ contient plusieurs points Voronoï $P_{Bj}$, la transmissivité entre deux noeuds fracture A et B est calculée comme la somme des transmissivités entre toutes les paires de cellules Voronoï appartenant à au noeud et ayant une face commune (figure 8).

$$T_{AB} = \sum_{i,j} T\left(P_{A_i}, T_{B_j}\right)$$

En cas d'assemblage, le « noeud fracture » ne correspondant pas aux noeuds de Voronoï, nous effectuons une correction de l'ensemble des transmissivités pour prendre en compte les modifications de distance pour les échanges de fluides. Cette modification dépend de la perméabilité affectée à chaque intersection de fractures (qui peut varier selon le modèle, de celle du plan de calcul à l'infini). On peut en effet vouloir modéliser une perméabilité différente le long de l'intersection de deux fractures, sans qu'elle soit infinie, par rapport à celle qui définit chacun des plans de fractures. Pour trouver la correction liée à la conductivité finie d'un segment d'intersection, on rajoute une transmissivité entre le centre C1 du noeud (ou géométriquement parlant du segment) A et un point Voronoï $P_{Ai}$, Ainsi si deux noeuds (ou plus) Voronoï appartiennent à un même noeud fracture (figure 9) de centre C1, la transmissivité $T_{S1S2}$ entre un noeud A et un noeud B est calculée comme suit :

$$T_{AB}^{corr} = \left( \frac{1}{T_{C_1A_i}} + \frac{1}{T_{A_iB_j}} + \frac{1}{T_{C_2B_j}} \right)^{-1}$$

Cette correction supprime l'hypothèse de conductivité infinie le long de la fracture si le choix du modèle impose $T_{C_1A_i} \neq 0$.

Pour être mis en oeuvre dans un logiciel et exécuté sur un ordinateur, les entrées de l'algorithme, peuvent être les suivantes :

- Zone d'intérêt: parallélépipède en 3D donné par la boite englobante (Xmin, Ymin, Zmin, Xmax, Ymax, Zmax) du domaine de simulation,

- Liste des fractures (polygones plans convexes en 3D donnés par des listes de sommets ordonnés) avec leurs propriétés hydrauliques isotropes dans chaque plan de fracture (perméabilité, épaisseur, compressibilité)

- Table de connectivité aux conditions limites (tableau indiquant à quel amas (celui de la taille maximale) appartient une fracture. Un amas est un groupement de fractures pour lesquelles il existe un chemin reliant chacun des membres)

- Liste des segments d'intersection 3D, et pour chaque fracture une liste de pointeurs vers les intersections correspondantes. Chaque intersection et sommet de fractures est exprimé, par changement de base, dans un repère local à la fracture. Ainsi, le problème général 3D est ramené en une succession de problèmes plans 2D.

Cette nouvelle technique de maillage du milieu fracturé permet de construire un maillage fin sur le réseau discret de fractures avec un nombre optimal de noeuds, proche du nombre d'intersections entre les fractures connectées.

- La connectivité du DFN à l'échelle de l'étude (une zone d'intérêt de quelques milliers de mètres carrés) est respectée dans le but de simuler des écoulements.

- Les cellules 3D du maillage fracturé sont construites à partir d'un diagramme de Voronoï de segments discrétisé selon le théorème de Koëbe sur chaque plan de fractures. Cette construction à l'avantage de:

  o limiter à un seul milieu homogène (le plan d'une fracture) l'espace d'échange entre deux noeuds fracture,

  o de respecter localement, l'orthogonalité entre la ligne de courant (entre deux noeuds) et la frontière des cellules et calculer aisément le gradient de pression entre les noeuds le long de la frontière,

  o prendre en compte la discontinuité due à toute intersection de fractures,

  o être décomposée en étapes simples, facilement parallélisables.

Cette nouvelle technique de maillage du milieu fracturé constitue donc une méthode semi-analytique utilisant un diagramme de Voronoï pour réduire le nombre de noeuds nécessaires à la simulation d'écoulements sur un réseau de fractures discrets. De ce fait, le procédé selon l'invention est applicable à des zones de calculs plus grandes que les procédés antérieurs.

Les résultats de cette méthode de maillage (les noeuds, leur volume et transmissivités associées) peuvent alors être utilisés en double milieu pour simuler des tests de puits, tests d'interférence ou un calcul de perméabilité équivalente. Cette méthode, appliquée ici au maillage du milieu fracturé 3D, s'applique à tout problème plan homogène peuplé par des segments d'hétérogénéités.

On rappelle ici la discrétisation des équations d'écoulement en double milieu (les pressions discrètes de chaque cellule N sont notées $P_{M,N}$ et $P_{F,N}$).

L'évaluation de la variation de pression pendant un temps $\Delta t$ est obtenue via un schéma implicite en temps ce qui conduit à :

$$\begin{cases} \int_{\Omega_F} \phi_F \chi \frac{P_F^{j+1} - P_F^{j}}{\Delta t} d\Omega - \int_{\partial\Omega_{FM}} \frac{\overline{\overline{K_F}}}{\mu} . \vec{\nabla} P_F^{j+1} . \vec{n}_M dS = \int_{\partial\Omega_F} Q_F^{j+1} . \vec{n}_{ext} dS \\ \int_{\Omega_M} \phi_M \chi \frac{P_M^{j+1} - P_M^{j}}{\Delta t} d\Omega + \int_{\partial\Omega_{FM}} \frac{\overline{\overline{K_M}}}{\mu} . \vec{\nabla} P_M^{j+1} . \vec{n}_M dS = \int_{\partial\Omega_M} Q_M^{j+1} . \vec{n}_{ext} dS \end{cases}$$

La variation spatiale de la pression est par la suite évaluée par une approche numérique en volumes finis :

$$\begin{cases} \sum_n \phi_{F,n} \chi \frac{P_{F,n}^{j+1} - P_{F,n}^{j}}{\Delta t} |\Omega_{F,n}| + \sum_n \sum_k T_{FF,nk} (P_{F,n}^{j+1} - P_{F,k}^{j+1}) + \sum_n \sum_l T_{FM,nl} (P_{F,n}^{j+1} - P_{M,l}^{j+1}) = \sum_n Q_{Fn}^{j+1} \\ \sum_n \phi_{M,n} \chi \frac{P_{M,n}^{j+1} - P_{M,n}^{j}}{\Delta t} |\Omega_{M,n}| + \sum_n \sum_k T_{MM,nk} (P_{M,n}^{j+1} - P_{M,k}^{j+1}) + \sum_n \sum_l T_{FM,nl} (P_{M,n}^{j+1} - P_{F,l}^{j+1}) = \sum_n Q_{Mn}^{j+1} \end{cases}$$

Pour simuler les tests de puits, il y a un effet de compressibilité, et un flux **Q** est imposé sur le lieu de prise de mesures de chacun des puits. Des conditions aux limites en pression pourront être appliquées sur les faces du parallélépipède d'étude, le système étant alors prétraité pour le réduire à **n** équations indépendantes.

$$\begin{bmatrix} \left( \chi \frac{\Phi_i V_i}{\Delta t^n} + \sum_{k \neq i} \frac{T_{ki}}{\mu} \right) & -\frac{T_{ij}}{\mu} \\ -\frac{T_{ij}}{\mu} & \end{bmatrix} \begin{pmatrix} P_i^n \end{pmatrix} = \begin{pmatrix} Q_{i\,\lim} + \sum_{0,nb\,\lim} \frac{T_{i,j\,\lim}}{\mu} P_{j\,\lim} \end{pmatrix} + \begin{pmatrix} \chi \frac{\Phi_i V_i}{\Delta t^n} P_i^{n-1} \end{pmatrix}$$

Avec :

$P_{j,lim}$ pression limite imposée au noeud temporaire **j_lim**,

$P_i^n$ pression inconnue dans le noeud **i** en temps **n**,

$\chi$ la compressibilité totale (milieu+fluide),

$\Delta t^n$ pas de temps courant,

$V_i$ volume du noeud **i**.

Le système est donc bien par construction à la diagonale dominante.

Pour le calcul de perméabilités équivalentes (MAE) pour chaque maille de réservoir, ces perméabilités équivalentes étant utilisées par la suite dans le simulateur d'écoulements à l'échelle du réservoir, on utilise les mêmes conditions aux limites que l'invention FR 2757947. Il convient alors de résoudre le système numérique discret suivant :

$$
\begin{bmatrix} & -T_{ij} \\ \sum_{k \neq i} T_{ki} & \\ -T_{ij} & \end{bmatrix} \cdot \begin{pmatrix} P_i \end{pmatrix} = \begin{pmatrix} \sum_{0,nb\,\lim} T_{i,j\,\lim} P_{j\,\lim} \end{pmatrix}
$$

avec:

$P_{j,lim}$ pression limite imposée au noeud *j_lim* pour un gradient de pression donné (ce terme varie pour les 3 systèmes résolus),

$P_i$ pression inconnue dans le noeud *i*.

Le système est donc bien par construction a diagonale dominante, indépendant de la compressibilité et de la viscosité.

3-b Construction d'un maillage du milieu matriciel **(MAT)**

La simulation d'écoulements en double milieu nécessite également de discrétiser le milieu matrice et de calculer des termes d'échange entre le milieu matrice et le milieu fracture. La nécessité de contraindre le champ de pression du milieu matrice au réseau de fractures nous a amené à proposer une nouvelle méthode de discrétisation 3D du milieu matrice pilotée par la géométrie du DFN 3D de simulation et ses hétérogénéités en espace par exemple (donc les hétérogénéités du milieu Fracture).

En effet, le champ de pression du milieu matrice dans une maille réservoir dépend, à priori, de la position des fractures et du rapport de conductivités hydrauliques entre le milieu Matrice et le milieu Fracture. Notamment, le milieu fracture est supposé plus conducteur que le milieu matrice. De ce fait, pour un même débit sur un intervalle de temps court, la variation de pression dans le milieu fracture peut être négligée en comparaison de celle dans le milieu matrice. Nous supposerons alors que les iso-pressions sont parallèles aux plans de fracture dans le milieu matrice. C'est à dire que pour une même distance (éventuellement corrigée par la perméabilité du milieu matrice) par rapport au milieu fracture, la pression est supposée constante dans le milieu matrice. Cette hypothèse permet de définir la direction du gradient de pression dans le milieu matrice et facilite ainsi le calcul des termes d'échange.

Pour discrétiser le milieu Matrice, nous utilisons un algorithme de type Octree. Un octree est une structure de données de type arbre dans laquelle chaque noeud peut compter jusqu'à huit enfants (octants). Les octrees sont le plus souvent utilisés pour partitionner un espace tridimensionnel en le subdivisant récursivement en huit octants.

Ainsi, pour construire les cellules du milieu matrice au sein d'une maille du modèle de réservoir (maille issue de la discrétisation du gisement), on divise la maille en huit mailles. Puis, si nécessaire, chacune de ces huit mailles est divisée en huit mailles. Et le processus continue jusqu'à ce que le maillage obtenu soit satisfaisant.

Pour ce faire, la technique de division par octree est réalisée de la façon suivante :

- Entrée de l'algorithme

- Zone d'intérêt: parallélépipède en 3D (tout ou partie du modèle de réservoir) donné par la boite englobante (Xmin, Ymin, Zmin, Xmax, Ymax, Zmax) du domaine de simulation,

- Liste des mailles fracture avec leurs propriétés géométriques (par exemple, des segments d'intersection entre fractures) et hydrauliques.

- Propriétés (porosité, perméabilité, compressibilité) du milieu Matrice en tout point de la zone d'étude

- Condition de raffinement

Le raffinement correspond à la division en huit octants. Selon l'invention, la condition de raffinement (condition pour que l'on divise à nouveau une maille en huit) est le nombre de noeuds fractures (ou toute autre forte discontinuité hydraulique) présents dans le parallélépipède rectangle de calcul (la maille issue d'une division).

Ainsi on divise la maille de réservoir en huit, puis encore en huit chaque maille issue de cette première division, jusqu'à ce que chaque maille issue de division comporte un nombre de fractures inférieur ou égal à un seuil donné (la condition de raffinement).

Ainsi, le problème plus général est décomposé en problèmes simplifiés composés d'une maille matrice parallélépipédique (la maille issue de la dernière division) et d'un nombre limité de fractures la traversant. En d'autres termes, la matrice est maillée plus finement dans les zones de complexité (au sens de la fracturation) plus élevée.

Selon la terminologie de l'algorithme de type Octree, on appelle « feuille de l'octree » l'objet de l'arbre qui ne peut plus être subdivisé compte tenu de la condition de raffinement de l'octree. Il s'agit donc, selon l'invention, d'une maille issue de la dernière division (maille possédant moins de fractures qu'un seuil donné).

Les feuilles de l'Octree sont destinées à devenir les mailles du milieu matrice. Il est donc important de garder une taille de parallélépipède du même ordre de grandeur entre voisins (~50%), pour permettre de bonnes simulations d'écoulement, au moyen de logiciels appelés simulateur d'écoulement. Pour se faire l'octree construit selon l'invention est équilibré d'ordre 1. Cette contrainte sur la construction de l'octree signifie que la différence de niveaux (nombre de subdivisions nécessaires pour accéder à la feuille courante, la racine étant du niveau 0) entre deux feuilles voisines dans l'octree ne peut pas excéder un. Ainsi, chaque noeud matrice ne peut avoir plus de quatre voisins dans chacune des six directions.

Selon un mode de réalisation préféré, on ajoute une troisième contrainte pour construire l'octree : une condition de raffinement liée à une limitation mémoire. Ainsi, on peut fixer un nombre maximal de mailles du milieu matrice. Lorsque le nombre de feuilles atteint ce niveau, la division cesse.

Une fois l'octree construit, chaque feuille correspond à une maille parallélépipédique issue de une ou plusieurs divisions. Le noeud du milieu matrice est alors placé au centre de ces mailles.

Ainsi, le maillage du milieu matrice est construit en respectant une contrainte liée aux fortes discontinuités du milieu Fracture grâce à l'utilisation d'un Octree équilibré d'ordre un avec contrainte de raffinement sur le nombre de fractures par feuille. Chaque feuille de l'octree porte l'information sur les noeuds fracture (et donc leur géométrie) qui la traversent. L'information de voisinage contenue dans l'octree et le fait que l'octree soit équilibré d'ordre un facilitent le calcul des termes d'échanges.

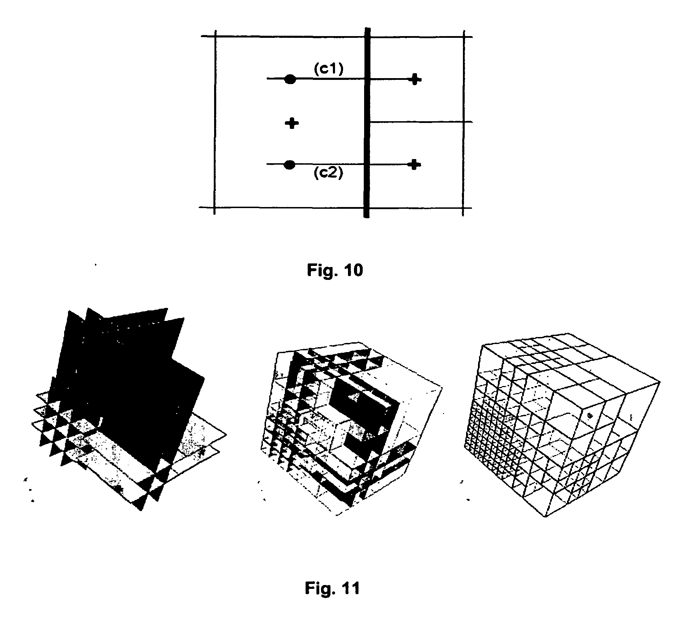

La figure 11 montre un maillage Matrice appliqué à un DFN, avec de gauche à droite : un réseau de densité de fractures variable dans l'espace, une zone Matrice associée au DFN pour le découpage par Octree, et le maillage du milieu matrice (correspondant au réseau de gauche) par la méthode objet de l'invention.

Calcul des termes d'échange Matrice/Fracture

Selon une première configuration possible : un noeud matrice échange avec plusieurs noeuds fracture.

Le principe de conservation des flux dans la cellule considérée permet d'écrire :

$$Q_{MF} = \sum_{i=1\ldots k} Q_{MF_i} \qquad \text{Eq 2}$$

où le flux échangé entre la maille matrice et le noeud fracture i $\Omega_{MF_i}$ vaut :

$$Q_{MF_i} = \frac{T_{MF_i}}{\mu}.(P_{Fi} - P_M) = \frac{1}{\mu} \int_{\partial\Omega_{Fi}} \overline{\overline{K_M}}.\bar{\nabla}P.\bar{n}_{Fi}dS \qquad \text{Eq 3}$$

d'où la transmissivité entre le noeud matrice M et le noeud fracture Fi :

$$T_{MF_i} = \frac{\int_{\partial\Omega_{Fi}} \overline{\overline{K_M}}.\vec{\nabla}P.\vec{n}_{Fi}dS}{(P_{Fi} - P_M)} \approx \frac{2S_{MF_i}\overline{\overline{K_M}}n_{F_i}.n_{F_i}}{\langle l_{mFi}\rangle_{\Omega_{M_i}}} \qquad \text{Eq 4}$$

Le volume d'influence du noeud fracture i, $\Omega_{Mi}$, est l'ensemble des points de la maille matrice dont le noeud fracture le plus proche est le noeud fracture i. On suppose qu'aucun flux ne circule entre ces volumes d'influence. Ils sont en effet délimités, par hypothèse, par une isopression puisqu'à égale distance des noeuds fracture.

$\langle l_{mFi}\rangle_{\Omega_{M_i}}$ est la distance moyenne par rapport au noeud fracture i sur $\Omega_{Mi}$.

Le volume d'influence peut être calculé de la façon suivante :

Par hypothèse, le gradient de pression est parallèle à la normale aux fractures. Pendant un faible intervalle de temps, la pression dans le milieu fracture varie peu en espace, elle est approximée au premier ordre par sa pression moyenne. Pour évaluer une pression locale matrice dans la maille, en supposant que le champ de pressions dans la matrice varie linéairement en fonction de la distance minimale par rapport à la fracture, il vient avec la formule de Taylor:

$$P_M(\cdot) = P_F + \nabla P_M(\cdot) l_{MF}(\cdot)n_F(\cdot) \qquad \text{Eq 1}$$

Les zones d'influence, $\Omega_{Mi}$, associées à chaque fracture présente dans la maille matrice considérée sont déterminées par un algorithme stochastique:

- tirage de points aléatoires dans la maille matrice (dans chacun des 8 octants),

- pour chaque point calcul de la distance à chaque plan fini de fracture,

- affectation de ce point au noeud fracture le plus proche pour évaluer les volumes d'influence,

- affectation de la distance à l'octant et calcul de la distance moyenne matrice/fractures dans chaque octant.

Il résulte de cet algorithme autant de fonctions densité (distance) que de noeuds fracture et une distance moyenne matrice/fractures dans chaque octant. La distance moyenne matrice fracture$\langle l_{mFi}\rangle_{\Omega Mi}$ ainsi que les volumes matrice associés au noeud fracture sont alors facilement calculables pour chaque noeud fracture. Nous pouvons également les pondérer par un terme en temps à expliciter pour modéliser l'écoulement transitoire.

Selon une seconde configuration possible : aucun noeud fracture n'appartient au volume associé au noeud matrice.

Dans le cas des écoulements double milieu (fractures + matrice), si aucune fracture ne traverse la cellule matrice, la cellule matrice considérée n'alimente le réseau de fractures que via l'échange matrice/matrice.

Pour le simple milieu (fractures seules), le volume d'influence de la cellule est ajouté à celui qui échange avec la fracture la plus proche (via la fonction de volume associée à un noeud fracture).

Calcul des termes d'échange Matrice/Matrice

Grâce à une construction équilibrée à l'ordre un de l'octree, dans chacune des six directions on assure qu'une cellule peut avoir 1 ou 4 cellules voisines par face.

La difficulté principale du calcul des transmissivités matrice/matrice est liée au fait que les lignes des iso-pressions $P_M$ sont corrélées à la géométrie des fractures, le gradient de pression macroscopique l'est donc lui aussi dans la maille.

La cellule a une seule cellule voisine dans la direction X

$$T_{ij} = \frac{(K_i + K_j)\Delta Y \Delta Z}{L}$$

<u>La cellule a quatre cellules voisines dans la direction X</u>

$$\frac{1}{T_{ij}} = \frac{L}{\Delta Y} \cdot \frac{1}{(\Delta X_i + \Delta X_j) \cdot \Delta Z}\left[\frac{\Delta X_i}{K_i} + \frac{\Delta X_j}{K_j}\right] \qquad\qquad \text{Eq 5}$$

La figure 10 illustre trois cellules de maillage matrice de taille différente, où le trait épais représente la frontière entre les cellules, une croix représente le centre d'une cellule, et une rond représente le centre d'une pseudo-cellule.

<u>5- Calibration des propriétés d'écoulement des fractures et du milieu matrice</u>

<u>Milieu fracture</u>

L'étape suivante consiste à déterminer les propriétés d'écoulement des fractures initiales (conductivité et ouverture des fractures), puis à calibrer ces propriétés au moyen de simulation de tests de puits sur des modèles d'écoulement locaux discrets, hérités de l'image réalistes du réseau réel (géologique) de fractures à l'échelle du réservoir. Bien que ne couvrant qu'une aire limitée (aire de drainage) autour du puits, un tel modèle de simulation de tests de puits comporte encore de très nombreux noeuds de calcul si le réseau de fractures est dense. En conséquence, la taille des systèmes à résoudre et/ou la durée des calculs demeurent souvent prohibitives.

La calibration des propriétés d'écoulement des fractures (conductivité et ouverture des fractures), localement autour des puits, nécessite, si nécessaire, la simulation de tests de puits.

Ce type de calibration est bien connu des spécialistes. On peut par exemple utiliser la méthode décrite dans le brevet FR 2.787.219. On simule, les réponses en écoulement de quelques puits (tests d'écoulement transitoires ou pseudo-permanents, interférences, débitmétrie, etc.) sur ces modèles extraits du modèle géologique donnant une image discrète (réaliste) des fractures alimentant ces puits. Puis, on compare le résultat de la simulation avec les mesures réelles effectuées aux puits. Si les résultats divergent, on modifie les paramètres statistiques (PSF) décrivant les réseaux de fractures, puis on redétermine les propriétés d'écoulement des fractures initiales, et on effectue une nouvelle simulation. L'opération est répétée jusqu'à ce que les résultats de simulation et les mesures convergent.

Les résultats de ces simulations permettent de calibrer (estimer) la géométrie et les propriétés d'écoulement des fractures, telles que les conductivités des réseaux de fractures du réservoir étudié et les ouvertures.

<u>6- Simulation des écoulements de fluides **(SIM)** et calibration des propriétés du milieu fracture **(OPT)**</u>

<u>6-a Procédé sans l'étape de mise à l'échelle</u>

A ce stade, l'ingénieur de réservoir dispose des données requises pour construire le modèle d'écoulement à l'échelle d'une ZOI ou d'une maille de réservoir. L'image est constituée d'une modélisation du réseau de fractures par un réseau discret de fracture (DFN) où chaque fracture est maillée par exemple avec les cellules de Voronoï renseignées en transmissivités (invention . Selon le processus choisit par l'ingénieur de réservoir, deux types de simulations peuvent être réalisés:

- la simulation du test du puits de courte durée permettant de calibrer les propriétés du modèle choisi près du puits.

Le modèle utilisé pour la simulation des écoulements sur le maillage 3D est basé sur les hypothèses suivantes :

• les écoulements sont monophasiques,

• le fluide et la roche sont faiblement compressibles,

• la température varie peu dans le réservoir,

- la viscosité du fluide est constante dans le réservoir,

- les écoulements en milieu poreux suivent une loi de Darcy dans la matrice et les fractures.

- la gravité est négligée mais la pression P peut être remplacée par (P+pgz) pour les simulations de tests de puits avec un postraitement approprié.

Si les capacités informatiques le permettent, du fait du faible nombre de noeuds issus de la méthode proposée, il est envisageable d'effectuer des simulations directement sur le réseau de fractures en utilisant la méthode, objet de l'invention.

6-b Simulation des écoulements de fluides **(SIM)** et optimisation des conditions de production du gisement **(OPT)**

A ce stade, l'ingénieur de réservoir dispose alors des données requises pour construire le modèle d'écoulement à l'échelle du réservoir. Les propriétés hydrauliques de fractures sont calibrées près du puits et mises à l'échelle sous la forme de perméabilités équivalentes sur l'ensemble des cellules de réservoir. Les simulations de réservoir fracturé adoptent souvent l'approche "double porosité", proposée par exemple par Warren J.E. et al. dans "The Behavior of Naturally Fractured Reservoirs", SPE Journal (septembre 1963), 245-255, et selon laquelle tout volume élémentaire (maille du modèle de réservoir) du réservoir fracturé est modélisé sous la forme d'un ensemble de blocs parallélépipédiques identiques, appelés blocs équivalents, délimités par un système orthogonal de fractures uniformes continues orientées suivant les directions principales d'écoulement. L'écoulement des fluides, à l'échelle du réservoir, s'effectue à travers les fractures seulement, et des échanges de fluides interviennent localement entre les fractures et les blocs matriciels. L'ingénieur de réservoir peut par exemple utiliser les méthodes décrites dans les documents suivants, appliquées à l'ensemble du réservoir cette fois : FR 2.757.947 (US 6.023.656), FR 2.757.957 (US 6.064.944) et EP 2 037 080.

L'ingénieur réservoir choisit un procédé de production, par exemple le procédé de récupération par injection d'eau, dont il demeure ensuite à préciser le scénario optimal de mise en oeuvre pour le champ considéré. La définition d'un scénario optimal d'injection d'eau consistera, par exemple, à fixer le nombre et l'implantation (position et espacement) des puits injecteurs et producteurs afin de tenir compte au mieux de l'impact des fractures sur la progression des fluides au sein du réservoir.

En fonction du scénario choisi, de l'image double milieu du gisement, et de la formule reliant le flux d'échange de masse et/ou d'énergie à la différence de potentiel matrice-fracture, on est alors capable de simuler la production d'hydrocarbures escomptée, au moyen du simulateur d'écoulement (logiciel) dit à double milieu.

A tout instant t de la production simulée, à partir des données d'entrées E(t) (données fixes ou variables au fur et à mesure du temps simulé), et de la formule reliant le flux (f) d'échange à la différence de potentiel (ΔΦ), le simulateur résout l'ensemble des équations propres à chaque maille et chacune des deux grilles du modèle (équations faisant intervenir la formule d'échange matrice-fracture décrite plus haut) et délivre ainsi les valeurs solutions des inconnues S(t) (saturations, pressions, concentrations, température, ...) à cet instant t. De cette résolution, découle la connaissance des quantités d'huile produites et de l'état du gisement (distribution des pressions, saturations, etc.) à l'instant considéré.

7- Exploitation optimisé du gisement **(EXPLO)**

On utilise l'image du gisement de fluide et un simulateur d'écoulement pour optimiser l'exploitation dudit gisement de fluide. En sélectionnant divers scénarios, caractérisés par exemple par diverses implantations respectives des puits injecteurs et producteurs, et en simulant la production d'hydrocarbures pour chacun d'eux selon l'étape 6 on peut sélectionner le scénario permettant d'optimiser la production du gisement fracturé considéré suivant les critères technico-économiques sélectionnés.

Les spécialistes exploitent alors le gisement selon ce scénario permettant d'optimiser la production du gisement.

**Variante**

Selon un mode de réalisation, on utilise également une structures de type arbres lors de la discrétisation du milieu fracture. A l'étape a) de Construction d'un maillage du milieu fracture (FRAC), on construit un diagramme de Voronoï sur chaque plan de fracture en positionnant des centres de cellules de Voronoï sur les segments d'intersection. L'octree permet d'accélérer la construction du maillage du milieu fracture en limitant le nombre de calcul d'intersections.

On construit ainsi un octree tel que décrit à l'étape 3b, mais pas forcément équilibré à ce stade. Les conditions de raffinement sont : le nombre de subdivisions (afin de fixer le nombre maximal de feuilles) et le nombre de fractures associées à une feuille.

On réalise ensuite un calcul accéléré des intersections entre les fractures en 3D en utilisant l'octree, car le nombre de fractures est réduit dans chaque subdivision.

Parallèlement aux calculs des termes d'échange Matrice/Matrice, la construction de l'Octree permet de scinder en espace les fractures qui n'auront pas d'interaction. Seules les fractures appartenant à une même feuille de l'octree feront l'objet d'un calcul de transmissivité fracture/fracture selon la méthode détaillée précédemment. Le calcul des intersections fractures/fractures très coûteux en 3D est ainsi limité aux fractures voisines en espace.

L'algorithme proposé a aussi la particularité de rendre possible et de faciliter la parallélisation des calculs à plusieurs niveaux :

- calcul des intersections entre fractures,

- calcul des termes d'échange Fracture/Fracture,

- calcul des termes d'échange Fracture/Matrice.

**Avantages**

La présente méthode de maillage double milieu permet de s'affranchir de l'hypothèse restrictive d'avoir autant de noeuds fracture que de noeuds matrice tout en préservant les volumes en place et la physique d'écoulement grâce à un schéma décentré.

L'utilisation des structures type arbre (et en particulier de l'octree) permet d'accélérer la construction du maillage du milieu fracture (limitation du nombre de calcul d'intersections), de simplifier les calculs de termes d'échange Matrice/Fracture ainsi que de bien estimer les volumes matrice associées aux noeuds fractures.

Cette méthode, appliquée ici au maillage d'un milieu dual en 3D, s'applique à tout problème dual impliquant de fortes hétérogénéités.

**Revendications**

1. Procédé pour optimiser l'exploitation d'un gisement de fluide traversé par un réseau de fractures, dans lequel on discrétise ledit gisement en un ensemble de mailles, chaque maille comportant un milieu matriciel et un milieu fracture, on construit en chaque maille à partir d'observations dudit gisement un réseau discret de fractures (DFN), **caractérisé en ce que** le procédé comporte les étapes suivantes :

   - on construit un maillage du réseau discret de fractures en définissant un ensemble de cellules pour chaque fracture ;
   - on construit un maillage du milieu matriciel en divisant chaque maille au moyen d'une technique d'octree, dans laquelle une maille est divisée en huit cellules, les cellules issues d'une division étant elles-mêmes divisées en huit, jusqu'à ce que chaque cellule issue de division comporte un nombre de fractures inférieur ou égal à un seuil donné ;
   - on détermine des transmissivités entre lesdites cellules du maillage de fracture, des transmissivités entre lesdites cellules du maillage du milieu matriciel, et des transmissivités entre des cellules du maillage de fracture et des cellules du maillage du milieu matriciel ;
   - on utilise lesdites cellules et les dites transmissivités pour construire une image du gisement de fluide ;
   - on utilise ladite image du gisement de fluide et un simulateur d'écoulement pour optimiser l'exploitation dudit gisement de fluide.

2. Procédé selon la revendication 1, dans lequel on construit le maillage du milieu matriciel au moyen d'une technique d'octree équilibré d'ordre 1.

3. Procédé selon l'une des revendications précédentes, dans lequel les cellules issues d'une division sont elles-mêmes divisées en huit, jusqu'à ce que chaque cellule issue de division comporte un nombre de fractures inférieur ou égal à un seuil donné, ou jusqu'à ce que ce que le nombre de cellules soit inférieur ou égal à un seuil donné.

4. Procédé selon l'une des revendications précédentes, dans lequel on détermine les transmissivités entre lesdites cellules du maillage du milieu matriciel et le milieu fracture en fonction d'un volume $\Omega_{M_i}$ d'influence d'un noeud fracture i défini comme l'ensemble des points d'une cellule du maillage du milieu matriciel dont le noeud fracture le plus proche est le noeud fracture i, et en fonction d'une distance moyenne $\langle l_{mFi}\rangle_{\Omega Mi}$ par rapport au noeud fracture i sur $\Omega_{M_i}$ et en supposant qu'aucun flux ne circule entre ces volumes d'influence.

**5.** Procédé selon l'une des revendications précédentes, dans lequel chaque fracture est représentée au sein du réseau discret de fractures par un plan fini polygonal isotrope du point de vue de ses propriétés dynamiques, ledit plan pouvant comporter au moins un segment d'intersection correspondant à une intersection entre ladite fracture et une autre fracture dudit réseau, et on réalise les étapes suivantes :

a) on construit un diagramme de Voronoï sur chaque plan de fracture en positionnant des centres de cellules de Voronoï sur lesdits segments d'intersection ;
b) on calcule des transmissivités entre des centres de cellules de Voronoï voisines à partir du rapport entre la surface des cellules voisines et la distance entre les cellules voisines.

**6.** Procédé selon la revendication 5, dans lequel on positionne les centres de cellules de Voronoï sur lesdits segments d'intersection, en appliquant la règle suivante : chaque segment d'intersection est au moins discrétisé par deux noeuds intermédiaires de Voronoï à chacune des extrémités dudit segment, et raffiné dans le cas de segments proches et de segments qui se croisent.

**7.** Procédé selon l'une des revendications 5 à 6, dans lequel on limite le nombre de cellules en procédant à un assemblage des cellules de Voronoï appartenant à un même segment d'intersection, tant que la cellule issue de l'assemblage reste connexe.

**8.** Procédé selon la revendication 7, dans lequel la transmissivité entre deux cellules issues de l'assemblage est égale à la somme des transmissivités via les frontières les séparant selon la conservation du flux.

**9.** Procédé selon l'une des revendications 5 à 8, dans lequel on détermine lesdits segments d'intersection au moyen d'une technique d'octree, dans laquelle une maille est divisée en huit cellules, les cellules issues d'une division étant elles-mêmes divisées en huit, jusqu'à ce que chaque cellule issue de division comporte un nombre de fractures inférieur ou égal à un seuil donné.

**Patentansprüche**

**1.** Verfahren zur Optimierung der Nutzung eines Fluidreservoirs, durch das ein Bruch-Netzwerk verläuft, bei dem das Reservoir in eine Einheit von Maschen diskretisiert wird, wobei jede Masche ein Matrixmedium und ein Bruchmedium umfasst, wobei an jeder Masche aus Beobachtungen des Reservoirs ein diskretes Bruch-Netzwerk (DFN) erstellt wird, **dadurch gekennzeichnet, dass** das Verfahren die folgenden Schritte umfasst:

- Herstellen eines Gitters des diskreten Bruch-Netzwerks, wobei eine Einheit von Zellen für jeden Bruch definiert wird;
- Herstellen eines Gitters des Matrixmediums, wobei jede Masche mit Hilfe einer Octree-Technik in acht Zellen geteilt wird, wobei die von einer Teilung stammenden Zellen selbst in acht geteilt werden, bis jede aus einer Teilung stammende Zelle eine Bruch-Anzahl kleiner oder gleich einer gegebenen Schwelle umfasst;
- Bestimmen der Durchlässigkeiten zwischen den Zellen des Bruch-Gitters, der Durchlässigkeiten zwischen den Zellen des Gitters des Matrixmediums und der Durchlässigkeiten zwischen den Zellen des Bruch-Gitters und den Zellen des Gitters des Matrixmediums;
- Verwenden der Zellen und der Durchlässigkeiten für die Herstellung eines Bildes des Fluidreservoirs;
- Verwenden des Bildes des Fluidreservoirs und eines Fließsimulators, um die Nutzung des Fluidreservoirs zu optimieren.

**2.** Verfahren nach Anspruch 1, bei dem das Gitter des Matrixmediums mit Hilfe einer ausgeglichenen Octree-Technik des Ranges 1 hergestellt wird.

**3.** Verfahren nach einem der vorhergehenden Ansprüche, bei dem die Zellen, die aus einer Teilung stammen, selbst in acht geteilt werden, bis jede Zelle, die aus einer Teilung stammt, eine Bruch-Anzahl kleiner oder gleich einer gegebenen Schwelle umfasst, oder bis die Anzahl von Zellen kleiner oder gleich einer gegebenen Schwelle ist.

**4.** Verfahren nach einem der vorhergehenden Ansprüche, bei dem die Durchlässigkeiten zwischen den Zellen des Gitters des Matrixmediums und dem Bruch-Medium in Abhängigkeit von einem Volumen $\Omega_{MI}$ des Einflusses eines Bruch-Knotens i, der als die Gesamtheit der Punkte einer Zelle des Gitters des Matrixmediums, dessen nächster Bruch-Knoten der Bruch-Knoten I ist, und in Abhängigkeit von einem durchschnittlichen Abstand $(I_{mFI})\Omega_{MI}$ in Bezug

zum Bruch-Knoten auf $\Omega_{MI}$ definiert ist, wobei angenommen wird, dass kein Strom zwischen diesen Einflussvolumina zirkuliert.

5. Verfahren nach einem der vorhergehenden Ansprüche, bei dem jeder Bruch innerhalb des diskreten Bruch-Netzwerks durch eine isotrope polygonale endliche Ebene aus Sicht seiner dynamischen Eigenschaften dargestellt ist, wobei die Ebene mindestens ein Schnittsegment umfassen kann, das einem Schnittpunkt zwischen dem Bruch und einem weiteren Bruch des Netzwerkes entspricht, wobei die folgenden Schritte durchgeführt werden:

   a) Erstellen eines Voronoi-Diagramms auf jeder Bruch-Ebene, wobei Zentren von Voronoi-Zellen auf den Schnittsegmenten positioniert werden;
   b) Durchlässigkeiten zwischen Zentren von benachbarten Voronoi-Zellen aus dem Verhältnis zwischen der Oberfläche der benachbarten Zellen und dem Abstand zwischen den benachbarten Zellen berechnet werden.

6. Verfahren nach Anspruch 5, bei dem die Zentren von Voronoi-Zellen auf den Schnittsegmenten unter Anwendung der folgenden Regel positioniert werden: jedes Schnittsegment ist mindestens durch zwei Voronoi-Zwischenknoten an jedem der Enden des Segments diskretisiert und im Falle von nahen Segmenten oder Segmenten, die einander kreuzen, verfeinert.

7. Verfahren nach einem der Ansprüche 5 bis 6, bei dem die Anzahl von Zellen begrenzt wird, wobei eine Zusammenfügung der Voronoi-Zellen, die einem selben Schnittsegment angehören, vorgenommen wird, solange die aus der Zusammenfügung stammende Zelle verbunden bleibt.

8. Verfahren nach Anspruch 7, bei dem die Durchlässigkeit zwischen zwei aus der Zusammenfügung stammenden Zellen gleich der Summe der Durchlässigkeiten über die sie trennenden Grenzen gemäß der Beibehaltung des Stroms ist.

9. Verfahren nach einem der Ansprüche 5 bis 8, bei dem die Schnittsegmente mit Hilfe einer Octree-Technik bestimmt werden, bei der eine Masche in acht Zellen geteilt wird, wobei die Zellen, die von einer Teilung stammen, selbst in acht geteilt werden, bis jede aus einer Teilung stammende Zelle eine Bruch-Anzahl kleiner oder gleich einer gegebenen Schwelle umfasst.

**Claims**

1. A method for optimizing the development of a fluid reservoir traversed by a fracture network, wherein said reservoir is discretized into a set of cells, each cell comprising a matrix medium and a fracture medium, and a discrete fracture network (DFN) is constructed in each cell from observations of said reservoir, **characterized in that** the method comprises the following stages:

   - constructing a mesh of the discrete fracture network by defining a set of cells for each fracture,
   - constructing a mesh of the matrix medium by dividing each cell by means of an octree technique, wherein a cell is divided into eight cells, the cells resulting from a division being themselves split in eight, until each cell resulting from a division comprises a number of fractures below or equal to a given threshold,
   - determining transmissivities between said cells of the fracture mesh, transmissivities between said cells of the matrix medium mesh, and transmissivities between cells of the fracture mesh and cells of the matrix medium mesh,
   - using said cells and said transmissivities for constructing an image of the fluid reservoir,
   - using said image of the fluid reservoir and a flow simulator for optimizing the development of said fluid reservoir.

2. A method as claimed in claim 1, wherein the matrix medium mesh is constructed by means of a first-order balanced octree technique.

3. A method as claimed in any one of the previous claims, wherein the cells resulting from a division are themselves split in eight, until each cell resulting from a division comprises a number of fractures below or equal to a given threshold, or until the number of cells is below or equal to a given threshold.

4. A method as claimed in any one of the previous claims, wherein the transmissivities between said cells of the matrix medium mesh and the fracture medium are determined as a function of a volume of influence $\Omega_{M_i}$ of a fracture node i defined as all of the points of a cell of the matrix medium mesh whose closest fracture node is fracture node i, and as a function of an average distance $\langle l_{mFi}\rangle_{\Omega Mi}$ to fracture node i on $\Omega_{Mi}$, and assuming that no flow circulates between these volumes of influence.

5. A method as claimed in any one of the previous claims, wherein each fracture is represented within the discrete fracture network by a polygonal finite plane, isotropic as regards its dynamic properties, and said plane can comprise at least one intersection segment corresponding to an intersection between said fracture and another fracture of said network, and the following stages are carried out:

   a) constructing a Voronoi diagram on each fracture plane by positioning Voronoi cell centers on said intersection segments,
   b) calculating transmissivities between neighbouring Voronoi cell centers from the ratio of the surface area of the neighbouring cells to the distance between the neighbouring cells.

6. A method as claimed in claim 5, wherein the Voronoi cell centers are positioned on said intersection segments by applying the following rule: each intersection segment is at least discretized by two intermediate Voronoi nodes at each end of said segment, and refined in the case of close segments and intersecting segments.

7. A method as claimed in any one of claims 5 to 6, wherein the number of cells is limited by assembling the Voronoi cells belonging to the same intersection segment, as long as the cell resulting from the assembly remains connected.

8. A method as claimed in claim 7, wherein the transmissivity between two cells resulting from the assembly is equal to the sum of the transmissivities via the boundaries between them according to the flow conservation.

9. A method as claimed in any one of claims 5 to 8, wherein said intersection segments are determined by means of an octree technique wherein a cell is divided into eight cells, the cells resulting from a division being themselves split in eight, until each cell resulting from a division comprises a number of fractures below or equal to a given threshold.

**Fig. 1**

Fig. 2

Fig. 3

Fig. 4

Fig. 5

Fig. 6

Fig. 7

**Fig. 8**

**Fig. 9**

**Fig. 10**

**Fig. 11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2757947
- FR 2787219
- US 6023656 A
- FR 2757957
- US 6064944 A
- EP 2037080 A

**Littérature non-brevet citée dans la description**

- **P. KOEBE.** *Kontaktprobleme der konformen Abbildung. Ber. S''achs. Akad. Wiss. Leipzig, Math.-Phys. Kl.,* 1936, vol. 88, 141-164
- **S. J. FORTUNE.** A sweepline algorithm for Voronoï diagrams. *Algorithmica,* 1987, vol. 2, 153-174
- **WARREN J.E et al.** The Behavior of Naturally Fractured Reservoirs. *SPE Journal,* Septembre 1963, 245-255